# EUROPEAN PATENT SPECIFICATION

(11) **EP 4 170 706 B1**
(45) Date of publication and mention of the grant of the patent: **09.12.2026**
(21) Application number: 21203706.3
(22) Date of filing: 20.10.2021
(51) Int. Cl.: H10W 20/00

(54) **A METHOD FOR PRODUCING AN INTEGRATED CIRCUIT CHIP COMPRISING A BACK-SIDE POWER DELIVERY NETWORK**
VERFAHREN ZUR HERSTELLUNG EINES CHIPS MIT INTEGRIERTER SCHALTUNG MIT EINEM RÜCKSEITIGEN STROMVERSORGUNGSNETZ
PROCÉDÉ DE PRODUCTION D'UNE PUCE DE CIRCUIT INTÉGRÉ COMPRENANT UN RÉSEAU DE DISTRIBUTION D'ÉNERGIE ARRIÈRE

(43) Date of publication of application: 26.04.2023
(73) Proprietor: Imec VZW, 3001 Leuven (BE)
(72) Inventor: Veloso, Anabela, 3001 Leuven (BE); Beyne, Eric, 3001 Leuven (BE); Jourdain, Anne, 1390 Grez-Doiceau (BE)
(74) Representative: Patent Department IMEC

(56) References cited:
- US-A1- 2013 175 673
- US-A1- 2020 152 508
- US-B1- 10 354 980

## Description

### Field of the Invention

The present invention is related to integrated circuit chips, hereafter abbreviated to ICs or IC chips, in particular to the aspect of the delivery of power to the active devices on the chip.

### State of the art.

Semiconductor processing for the fabrication of integrated circuit chips continues to evolve towards increasing device-density : higher numbers of active devices (mainly transistors) of ever decreasing device dimensions are placed on a given surface of semiconductor material.

As conventional CMOS scaling is reaching its physical limits and facing increasingly constraining design restrictions, new, alternative solutions are required to help preserve the overall power-performance-area-cost (PPAC) logic roadmap and continue delivering profitable node-to-node scaling gains. Introduction of buried power rails (BPR) and a back-side power delivery network (PDN) have been proposed to address interconnect congestion issues by enabling further scaling with extra routing options.

The combined application of BPR and a back side PDN is described for example in patent publication document EP3324436A1. This document proposes to connect the buried power rails from the back side of the semiconductor layer onto which the active devices are formed. After thinning a device wafer to thereby expose the back side of the semiconductor layer, small Through Silicon Via connections (often called "nano"-TSVs) are realized from said exposed backside, contacting the buried power rails. On the back surface, parallel power delivery tracks form a pattern of alternating VDD and VSS-coupled lines with Patent publication US2020/152508 also discloses buried power rails and describes a method wherein the rails and nanoTSVs between said rails and the back of the substrate are formed prior to producing the active devices. narrow pitch.

The nanoTSVs however represent a restriction in terms of the resistivity of the power supply path to the active devices on the front side. Also, as buried power rails are processed from the font side of a device wafer, the material choice for these buried rails is limited to materials which are compatible with the thermal budget for front side processing. This excludes a number of low-resistivity materials.

The improvement of contact resistances is another ongoing concern in the development of IC chip designs. For example, the contact resistance between nanoTSVs and back side power supply tracks is often unsatisfactory because of the material choices and dimensional restrictions related to TSV processing.

### Summary of the invention

The invention aims to provide a solution to the problems highlighted above. This is achieved by a method for producing an IC chip in accordance with the appended claims. According to the method of the invention, deep trenches are formed in a semiconductor layer that forms the top layer of a device wafer, the trenches going through the complete thickness of the layer. The trenches are filled with a sacrificial material, that is subsequently etched back and covered with a capping layer thereby forming sacrificial buried rails. After processing the active devices of the IC on the front surface of the semiconductor layer, including connections to the sacrificial rails, the device wafer is bonded face down to a carrier wafer, and thinned from the back side, until the sacrificial rails are exposed. The sacrificial material and the capping layer are removed and replaced by a conductive material, thereby forming the actual buried power rails. This is followed by further back side processing to form a back side power delivery network to supply power through the buried rails to the active devices of the IC.

Using a sacrificial material for the buried rails enables a wider choice of materials for these buried rails.

The invention is in particular related to a method according to the claims.

### Brief description of the figures

The enclosed figures are illustrating the main features of the invention. They are not drawn to scale and should not be regarded as technical drawings of real structures.
Figures 1 shows a section view and a plane view of a portion of a device wafer comprising p-type fins and n-type fins, and onto which one embodiment of the method of the invention will be applied with reference to the subsequent figures.
Figures 2 to 16 illustrate a sequence of key steps illustrating one embodiment of the method of the invention.

### Detailed description of the invention

In the following detailed description, the method according to the invention is described on the basis of one embodiment of the method, for producing an integrated circuit chip comprising a CMOS layout of finFET transistors arranged in standard cells on a semiconductor substrate. However, the invention is not limited to this particular application field, as will be made clearer after the description of the embodiment in question. Any reference to materials used for the various layers and areas that will be described is merely intended as an example of suitable materials and is not to be understood as a limitation of the scope of the present invention.

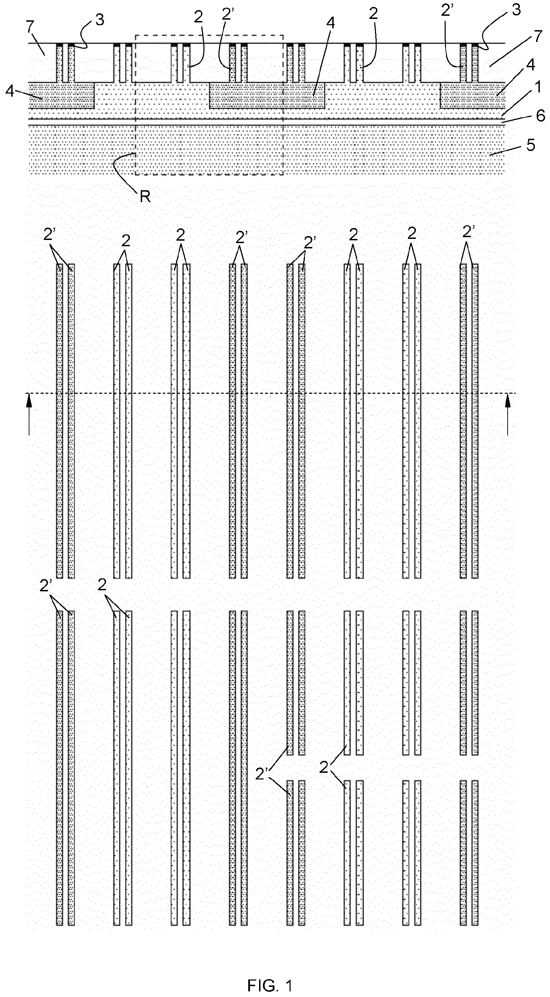

Figure 1 shows a small portion of a device wafer (i.e., a wafer onto which active devices of IC chips are to be processed), comprising a monocrystalline Si layer 1, into which a number of fins 2 and 2' have been produced by a known lithography and etch technique, applying etch masks 3. The width of the fins may be in the order of 10 nm or less. The two different types of hatching indicate different doping types (referred to also by respective references 2 and 2'), typically p-type and n-type doping. In the embodiment shown, the Si layer 1 could be a p-type layer, implanted with n-type dopants in well-areas 4. The well-areas 4 reach about half the depth of the Si layer 1 but could also reach to the back surface of the Si layer. The image is merely a schematic indication of the fact that adjacent p- and n-areas are created on the device wafer. This layout is typically used for producing pMOS and nMOS transistors arranged in multiple standard cells. In this example, the layout comprises regularly spaced pairs of fins arranged in alternate groups of four p-type fins 2 and four n-type fins 2'. As seen in the plane view in Figure 1, the fins are cut in their length direction in accordance with a suitable layout for an area of the IC chip that is to be processed in said area.

The Si layer 1 is a monocrystalline top layer of a multi-layer device wafer comprising a base wafer 5, typically a Si wafer, and a thin etch stop layer 6, which could be a SiGe layer. The Si layer 1 (including the fins) preferably has a thickness less than 1 µm, for example about 500 nm. The etch stop layer 6 may be a SiGe layer of about 50nm thick for example. Its function as an etch stop layer is to stop the etching of the base wafer 5 from the back side, as will be explained later in this description. The SiGe layer 6 and the monocrystalline Si layer 1 may be produced on a Si base wafer 5 by techniques well known in the art, preferably by epitaxial growth methods. An alternative would be to use a silicon-on-insulator (SOI) wafer, wherein the insulator layer plays the part of etch stop layer later in the process. The fins 2, 2' are embedded in a layer 7 of dielectric material. Typically, this is a layer of silicon oxide (SiO₂), also referred to as 'shallow trench isolation' oxide. We will hereafter refer to this layer as the STI layer 7. Layer 7 may be applied by any known technique, that may include a densification anneal step applying a thermal budget that is compatible with the material of the etch stop layer 6. The STI layer 7 may include a liner that follows the topography of the fins, for example a thin SiN layer, with a SiO₂ deposited on top of the SiN layer.

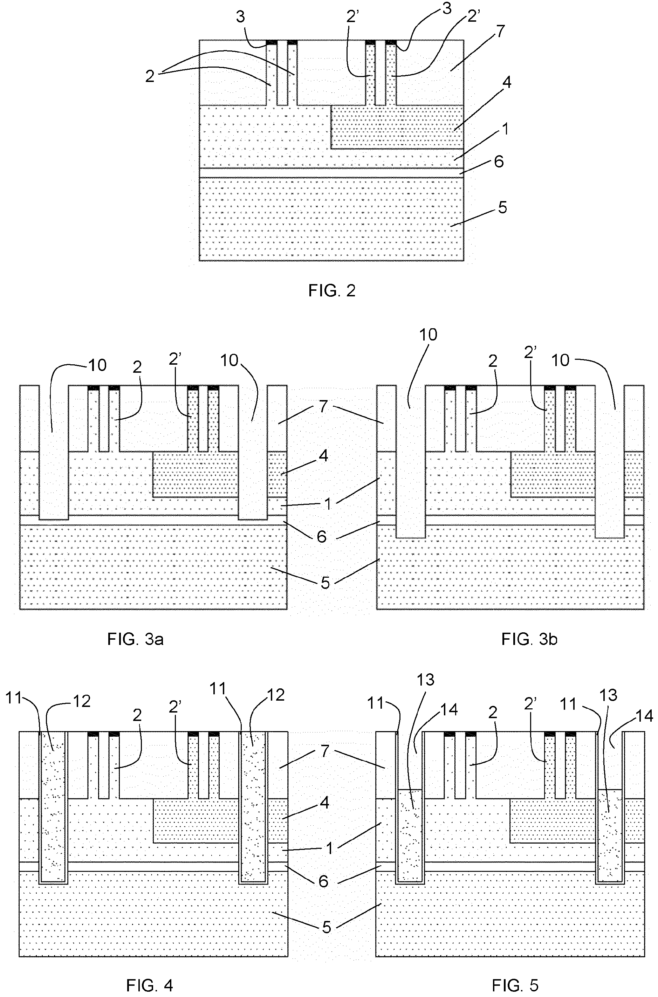

Figure 2 is an enlarged image of the part of the section view of Figure 1 indicated by the rectangle R, including two p-type fins 2 and two n-type fins 2'. In a method step that is characteristic for the method of the invention and illustrated on the basis of two alternative embodiments illustrated in Figures 3a and 3b, deep trenches 10 are etched by anisotropic etching through the complete thickness of the Si layer 1, in the areas between consecutive pairs of fins of the same type in Figure 1, i.e., on either side of the two pairs of fins shown in Figure 2. In their length direction, the trenches 10 span across a given area of the fin layout of which a part is shown in the plane view of Figure 1. The width of the trenches 10 is shown to be significantly larger than the width of the fins 2,2' but this is mostly in order to be able to clearly show a number of aspects of the method later on. In reality the trenches 10 could be narrower than shown in the drawings.

The trenches 10 may reach into the SiGe layer 6 as illustrated in Figure 3a or pass through the SiGe layer 6 and partially into the base wafer 5, as illustrated in Figure 3b. The formation of these trenches is typically realised by lithography and etch techniques known as such in the art and therefore not described here in detail.

It is to be noted that while the SiGe layer 6 is described as an etch stop layer, the etch stop function does not refer in the first place to etch recipes for producing the trenches 10. So, while it would be possible to use a first etch recipe for etching Si selectively to SiGe, i.e., an etch process that stops on the SiGe layer 6 and thereafter another etch recipe that allows to continue the etch process into and possibly through the SiGe layer 6, it is also possible to use an etch recipe that removes both Si and SiGe.

According to an embodiment, such an etch recipe is used that removes both Si and SiGe, and the material that is released from the Si layer 1 and from the SiGe layer 6 during the etch process is monitored by spectrometry as the etch progresses, so that the time may be detected when the SiGe layer 6 is reached. The etch process could then be stopped or continued further into the SiGe layer (as in Figure 3a), or fully through the SiGe layer and into the base wafer 5 (as in Figure 3b).

Alternatively, a timed etch can be applied, wherein the etch time is determined beforehand based on known etch speeds and the dimensions of the etched areas. The spectrometry-based approach however enables to obtain a more accurate control of the depth of the trenches 10. This spectrometry-based monitoring has not been used in this particular context, i.e., for controlling the etch depth of trenches applied for the purpose of producing buried power rails of an IC chip. The approach is possible here because the trenches 10 are etched through the complete thickness of the semiconductor layer 1, whereas prior art techniques include etching only partially into the layer 1 and possibly locally continuing the etch to form via openings to the back of the layer 1. As the trenches are now etched entirely through the thickness of the semiconductor layer 1, it is believed that the amount of released material is sufficient to enable the spectrometry-based monitoring approach described above. Any known spectrometry equipment configured to detect the materials in question could be used for this purpose.

The description of the method is continued in Figure 4, using the alternative shown in Figure 3b, i.e., trenches etched completely through the SiGe layer 6 and into the base wafer 5. A dielectric liner 11 is formed on the inner surfaces of the trenches 10, i.e., on the bottom and the sidewalls. This could be a layer of titanium nitride formed by atomic layer deposition (ALD). The thickness of the liner 11 is in accordance with thicknesses generally applied for dielectric liners formed around buried power rails to isolate the rails from the surrounding material.

Then the trenches 10 are filed with a sacrificial material 12, i.e., a material that is to be removed again later in the process. The upper surface of the device wafer is then planarized using a suitable planarization technique known in the art, such as CMP (chemical mechanical polishing), resulting in the image shown in Figure 4. The sacrificial material 12 could a metal such as tungsten (W), deposited by ALD or chemical vapour deposition, or a non-metal such as amorphous silicon.

With reference to Figure 5, the sacrificial material is then etched back from the front side of the device wafer, for example (and as shown in the drawings) to just above the base of the fins 2,2'. In general, it is required that the remaining thickness of sacrificial material corresponds to a suitable thickness for the buried power rails that will ultimately replace the sacrificial material. The remaining volumes of the sacrificial material will be referred to as 'sacrificial rails' 13. After etching back the sacrificial material, shallow trenches 14 (meaning shallower than the original trenches 10) appear above the sacrificial rails 13.

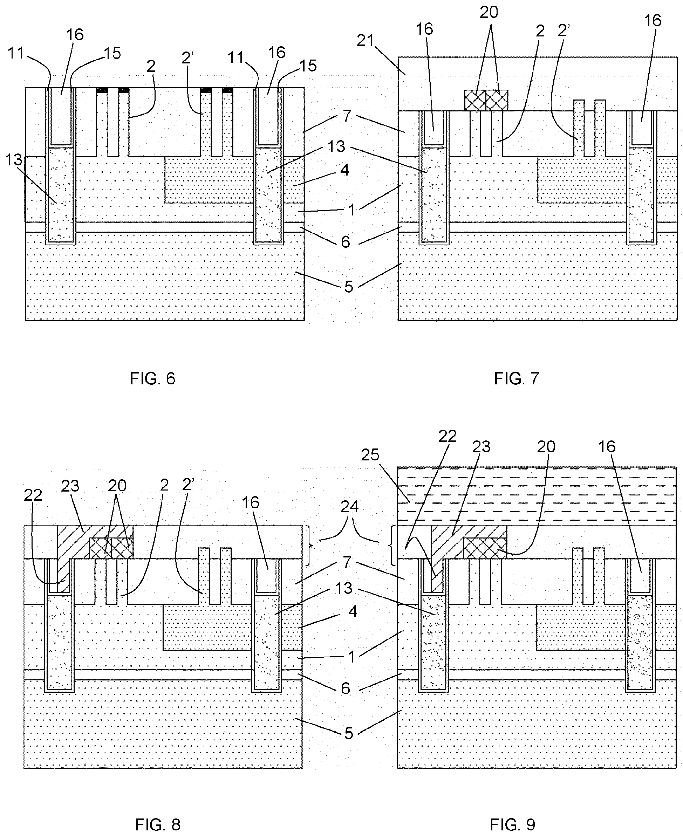

In the next step, illustrated in Figure 6, a capping layer 15 is applied on the inner surfaces of the shallow trenches 14, i.e., on the bottom and sidewalls thereof. The capping layer 15 is preferably a dielectric layer and could be a thin SiN layer applied for example by ALD. The thickness of the capping layer 15 is in the same order of magnitude as the thickness of the dielectric liner 11. The function of the capping layer 15 is to protect the sacrificial rails 13 during front side processing applied for producing active devices and connections from these devices to the sacrificial rails (see further). Any material that is suitable for performing this function can be used as the capping layer. The capping layer thus enables the full decoupling of the front side processing steps from the formation of the actual buried rails (see further), so that a wider choice of materials for these rails becomes available.

The shallow trenches 14 are then filled with a dielectric material 16, possibly this may be the same material as the STI layer 7, for example SiO₂, applied by the same method that may include a densification anneal compatible with the SiGe etch stop layer 6, and the wafer is again planarized, resulting in the view shown in Figure 6.

Then a number of well-known CMOS process steps is performed, of which the result is illustrated in a simplified way in Figure 7. This is the processing of source or drain (S/D) contacts 20 of transistors on the fins 2,2', in accordance with a given layout of standard cells arranged between the sacrificial rails 13. As known in the art, the STI layer 7 is etched back to expose the top of the fins, and the S/D contacts 20 are formed thereon by epitaxial techniques well known in the art. Contacts are shown only on the p-type fins 2 in the drawing. The n-type fins may equally be provided with contacts lying outside the plane of the drawing. Additional steps for forming transistors or other active devices are performed, such as gate processing steps (not shown). The active devices are covered by another dielectric layer 21 followed by a planarization step.

Figure 8 shows the result of additional process steps which are known as such, but which are performed normally when buried power rails are already present in the Si layer 1, as opposed to the sacrificial rails 13 formed according to the method of the invention. These process steps are sometimes referred to as the formation of a 'VPBR' (via to BPR) 22 and MOA connection 23 (electrically conductive connection to S/D contacts). In the drawings, the VPBR and the MOA are drawn as one integral area, and it is in fact possible to form this area in one deposition step. However, the VBPR and the MOA can also be formed in separate steps. As stated, such steps are known as such and therefore not detailed here. They include lithography and etch steps for forming cavities corresponding to the VBPR and MOA areas, and filling of the cavities with an electrically conductive material, preferably metal, after which the wafer's top surface is planarized. In Figure 8 the top area of the device wafer at this stage of the method is referred to as the front end of line portion 24 of the IC. The '{' is merely an indicative sign of the location of the FEOL portion 24, without meaning to define an exact border.

As shown in Figure 9, the method continues with the formation of the BEOL portion 25, the latter being a stack of interconnects comprising several metallization levels (M1,M2 etc), including a passivation layer on top (not shown), as well-known in the art. The MOA connections 23 are indicated as part of the front end of line portion 24 in the drawings. They could however be regarded as part of the BEOL portion 25 (see further). This distinction has no bearing on the characterising features of the present invention.

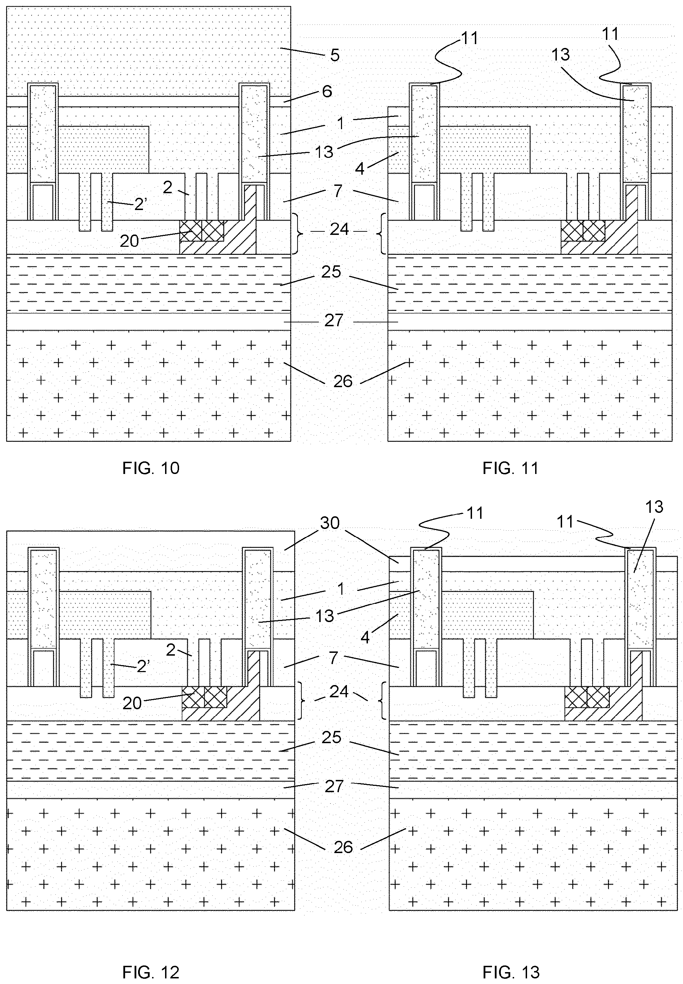

Back side processing is now performed, after flipping the wafer and bonding it to a carrier wafer 26, preferably applying dielectric bonding layers 27 (shown as one bonded layer in the drawings) to the carrier 26 and to the BEOL stack 25 , as illustrated in Figure 10.

The base wafer 5 is removed by a thinning sequence that may comprise etching and/or grinding steps, ending with a highly selective etch step, preferably a wet etch in the case of a SiGe etch stop layer 6, that effectively stops when reaching the SiGe layer 6. Such highly selective etch recipes are well known for the selective etch of Si relative to SiGe as well as for other material combinations. Following this, the etch stop layer 6 itself is removed, resulting in the situation illustrated in Figure 11, with the sacrificial rails 13, including the liner 11, protruding outward from the back surface of the Si layer 1. If necessary, the material of the Si layer 1 is slightly recessed in order to obtain this result.

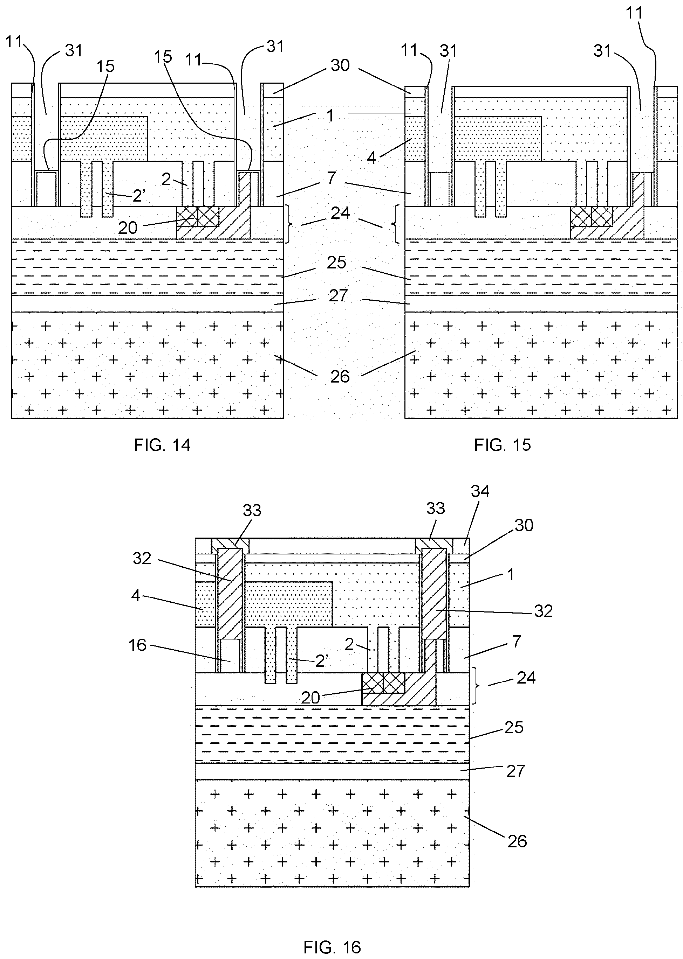

A dielectric layer 30 (e.g. SiO₂) is deposited on the wafer and planarized (see Figure 12), and thereafter etched back to expose a portion of the sacrificial rails 13. As shown in Figure 13, said portion may protrude from the dielectric layer 30. Using etch recipes with the required selectivity, the liner 11 is removed from the protruding portion of the rails 13, and the sacrificial rails 13 themselves are removed relative to the liner 11 and the capping layer 15, resulting in the view shown in Figure 14. If the sacrificial rails 13 are formed of W, the W may be removed using an APM (ammonia peroxide mixture) solution. The removal of the sacrificial rails results in trenches 31 formed through the back surface of the Si layer 1, with the capping layer 15 forming the bottom of these back side trenches 31.

With reference to Figure 15, the capping layer 15 is then removed from the bottom of the trenches 31, which may be done by a dry or wet etch process, that is likely to also thin the dielectric layer 30 on the back surface of the Si layer. The initial thickness of the dielectric layer 30 in the view shown in Figure 13 must therefore be sufficient in order for this layer not to be removed completely when the capping layer 15 is removed from the bottom of the back side trenches 31.

Thereafter, the back side trenches 31 are filled with an electrically conductive material, preferably a metal, followed by planarizing the back surface, as shown in Figure 16, thereby forming the conductive buried power rails 32 which are electrically connected to the VBPRs 22 and thereby to the MOA connections 23, i.e. to the active devices on the front surface of the Si layer 1. The choice of the material for the power rails 32 is much more free compared to the prior art methods, in which the power rails are formed prior to the formation of the FEOL and BEOL portions of the IC. This allows a choice of materials with lower resistivity compared to prior art devices.

Metallization steps are then performed on the back side to form the back side power delivery network, starting for example with the formation of metal tracks 33 connected to the power rails, see Figure 16, showing these tracks embedded in a dielectric layer 34. Through additional interconnect layers of the PDN (not shown), these tracks are to be connected to power supply terminals from which power may be supplied, through the PDN and the power rails 32, to the active devices arranged in standard cells between the power rails 32. Before forming the metal tracks 33, the dielectric layer 30 could be recessed relative to the power rails 32, which enables to increase the contact surface between the rails and the tracks.

Further steps to produce the actual IC chips are well known in the art, and therefore not described in detail. Such steps include singulating the device wafer for example by cutting or sawing, to obtain separate IC chips.

The invention is not limited to an IC comprising fin-based devices. The method can be applied in the production of any type of known active devices on the front surface of the Si layer 1. The devices could be nano-sheet based devices, well known in the art, wherein stacks of nano-sheets are processed on the front surface of the Si layer 1, said stacks have a similar profile to the fins 2 and 2' shown in the drawings.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

The foregoing description details certain embodiments of the invention. It will be appreciated, however, that no matter how detailed the foregoing appears in text, the invention may be practiced in many ways, and is therefore not limited to the embodiments disclosed. It should be noted that the use of particular terminology when describing certain features or aspects of the invention should not be taken to imply that the terminology is being re-defined herein to be restricted to include any specific characteristics of the features or aspects of the invention with which that terminology is associated.

Unless specifically specified, the description of a layer being present, deposited or produced 'on' another layer or substrate, includes the options of
- said layer being present, produced or deposited directly on, i.e. in physical contact with, said other layer or substrate, and
- said layer being present, produced or deposited on one or a stack of intermediate layers between said layer and said other layer or substrate.

## Claims

1. A method for producing an integrated circuit chip, comprising the steps of :
- providing a device wafer comprising a semiconductor layer (1) on top, said layer having a front surface and a back surface,
- thereafter, producing a plurality of mutually parallel deep trenches (10) through the complete thickness of the semiconductor layer (1),
- thereafter, filling the trenches (10) with a sacrificial material,
- thereafter, etching back the sacrificial material to form buried rails (13) of sacrificial material, hereafter referred to as sacrificial rails, with shallow trenches (14) formed above the sacrificial rails (13),
- thereafter, producing a capping layer (15) on the inner surfaces of the shallow trenches (14),
- thereafter, filling the shallow trenches (14) with a dielectric material (16),
- thereafter, performing the following steps :
∘ producing contacts (20) for the production of active devices on the front surface of the semiconductor layer (1),
∘ forming cavities by lithography and etch steps and filling said cavities with an electrically conductive material, thereby forming electrically conductive connections (22,23) between a plurality of the contacts (20) and the sacrificial rails (13), without removing the capping layer (15),
∘ producing said active devices thereby forming a front end of line portion (24) of the IC chip,
- thereafter, producing a stack of interconnect layers on said active devices, thereby forming a back end of line portion (25) of the IC chip,
- thereafter, flipping the device wafer and bonding the wafer to a carrier wafer (26),
- thereafter, thinning the device wafer from the back side thereof until the sacrificial rails (13) protrude outward from the back surface of the semiconductor layer (1), wherein if necessary, the semiconductor layer itself is thinned relative to the sacrificial rails (13),
- thereafter, depositing a dielectric layer (30) on the back surface of the semiconductor layer (1), embedding the protruding portions of the sacrificial rails (13), and thinning the dielectric layer (30) until the sacrificial rails (13) are exposed,
- thereafter, removing the sacrificial material, thereby forming back side trenches (31) starting from the back surface of the dielectric layer (30) and reaching down to the capping layer (15), so that said capping layer forms the bottom of the back side trenches (31),
- thereafter, removing the capping layer (15) from said bottom of the back side trenches (31),
- thereafter, filling the back side trenches (31)with an electrically conductive material, thereby forming buried power rails (32) that are contacting said electrically conductive connections (22,23),
- thereafter, planarizing the wafer until the dielectric layer (30) and the buried power rails (32) are exposed,
- thereafter, producing a back side power delivery network including conductors (33) formed on the dielectric layer (30) for contacting the buried power rails (32) from the back surface of the semiconductor layer (1),
- thereafter, singulating the device wafer thereby forming the integrated circuit chip, wherein a singulated portion of the semiconductor layer (1) forms the substrate of the IC chip, said substrate comprising active devices on its front surface and a power delivery network on its back surface, wherein the power delivery network is connected to the active devices through the buried power rails (32).

2. The method according to claim 1, further comprising depositing a dielectric liner (11) on the inner surfaces of the parallel deep trenches (10), before depositing the sacrificial material therein.

3. The method according to claim 1, wherein the device wafer comprises a base wafer (5), an etch stop layer (6) on the base wafer, and said semiconductor layer (1) on the etch stop layer, wherein the etch stop function of the etch stop layer (6) is related to stopping an etch process applied during said step of thinning the device wafer from the back side thereof.

4. The method according to claim 3, wherein the deep parallel trenches (10) reach into the etch stop layer (6).

5. The method according to claim 3, wherein the deep parallel trenches (10) are formed through the complete thickness of the etch stop layer (6) and into the base wafer (5).

6. The method according to any one of claims 4 or 5, wherein a spectrometry method is used to monitor the depth of the trenches (10), as these trenches are being formed using an etch process, by detecting materials released from the semiconductor layer (1) and from the etch stop layer (6).

7. The method according to any one of the preceding claims, wherein the active devices are fin-based devices or nano-sheet based devices and wherein the buried power rails (32) run parallel to the fins (2,2') or to the nano-sheets of said active devices.

8. The method according to any one of the preceding claims, wherein the sacrificial material is tungsten or amorphous silicon.

9. The method according to any one of the preceding claims, wherein the capping layer (15) is a dielectric layer.

10. The method according to claim 9, wherein the capping layer (15) is a silicon nitride layer.

## Patentansprüche

1. Erzeugungsverfahren eines Chips mit integrierten Schaltung, das die folgenden Schritte umfasst:
- Bereitstellen eines Vorrichtungswafers, der eine Halbleiterschicht (1) auf der Oberseite umfasst, wobei die Schicht eine Vorderfläche und eine Rückfläche aufweist,
- anschließendes Erzeugen einer Vielzahl zueinander paralleler tiefer Gräben (10) durch die gesamte Dicke der Halbleiterschicht (1) hindurch,
- anschließendes Füllen der Gräben (10) mit einem Opfermaterial,
- anschließendes Rückätzen des Opfermaterials, um vergrabene Schienen (13) aus Opfermaterial zu bilden, die nachstehend als Opferschienen bezeichnet werden, wobei über den Opferschienen (13) flache Gräben (14) gebildet werden,
- anschließendes Erzeugen einer Deckschicht (15) auf den Innenflächen der flachen Gräben (14),
- anschließendes Füllen der flachen Gräben (14) mit einem dielektrischen Material (16),
- anschließendes Durchführen der folgenden Schritte:
- Erzeugen von Kontakten (20) für die Erzeugung aktiver Vorrichtungen der Vorderfläche der Halbleiterschicht (1),
- Bilden von Hohlräumen durch Lithographie und Ätzschritte und Füllen der Hohlräume mit einem elektrisch leitfähigen Material, wodurch elektrisch leitfähige Verbindungen (22, 23) zwischen einer Vielzahl von Kontakten (20) und den Opferschienen (13) gebildet werden, ohne die Deckschicht (15) zu entfernen,
- Erzeugen der aktiven Vorrichtungen, wodurch ein Front-End-of-Line-Abschnitt (24) des IC-Chips gebildet wird,
- anschließendes Erzeugen eines Stapels von Verbindungsschichten auf den aktiven Vorrichtungen, wodurch ein Backend-of-Line-Abschnitt (25) des IC-Chips gebildet wird,
- anschließendes Umdrehen des Vorrichtungswafers und Verbinden mit einem Träger-Wafer (26),
- anschließendes Ausdünnen des Vorrichtungswafers von der Rückseite davon, bis die Opferschienen (13) aus der Rückfläche der Halbleiterschicht (1) herausragen, wobei, soweit erforderlich, die Halbleiterschicht selbst in Bezug auf die Opferschienen (13) ausgedünnt wird,
- anschließendes Abscheiden einer dielektrischen Schicht (30) auf der Rückfläche der Halbleiterschicht (1), Einbetten der überstehenden Abschnitte der Opferschienen (13), und Ausdünnen der dielektrischen Schicht (30), bis die Opferschienen (13) freigelegt sind,
- anschließendes Entfernen des Opfermaterials, wodurch Rückseitengräben (31) gebildet werden, die von der Rückfläche der dielektrischen Schicht (30) ausgehen und derart bis zu der Deckschicht (15) hinunter reichen, dass die Deckschicht den Boden der Rückseitengräben (31) bildet,
- anschließendes Entfernen der Deckschicht (15) vom Boden der rückseitigen Gräben (31),
- anschließendes Füllen der rückseitigen Gräben (31) mit einem elektrisch leitfähigen Material, wodurch vergrabene Stromschienen (32) gebildet werden, die mit den elektrisch leitfähigen Verbindungen (22, 23) kontaktieren,
- anschließendes Planarisieren des Wafers, bis die dielektrische Schicht (30) und die vergrabenen Stromschienen (32) freigelegt sind,
- anschließendes Produzieren eines rückseitigen Stromversorgungsnetzwerks, das auf der dielektrischen Schicht (30) ausgebildete Leiter (33) zum Kontaktieren der vergrabenen Stromschienen (32) von der Rückfläche der Halbleiterschicht (1) beinhaltet,
- anschließendes Vereinzeln des Vorrichtungswafers, wodurch der Chip mit integrierter Schaltung gebildet wird, wobei ein vereinzelter Abschnitt der Halbleiterschicht (1) das Substrat des IC-Chips bildet, wobei das Substrat auf seiner Vorderfläche aktive Vorrichtungen und auf seiner Rückfläche ein Stromversorgungsnetzwerk umfasst, wobei das Stromversorgungsnetzwerk durch die vergrabenen Stromschienen (32) mit den aktiven Vorrichtungen verbunden wird.

2. Verfahren nach Anspruch 1, das weiter Abscheiden einer dielektrischen Auskleidung (11) auf den Innenflächen der parallelen tiefen Gräben (10) vor dem Abscheiden des Opfermaterials umfasst.

3. Verfahren nach Anspruch 1, wobei der Vorrichtungswafer einen Basis-Wafer (5), eine Ätzstoppschicht (6) auf dem Basis-Wafer und die Halbleiterschicht (1) auf der Ätzstoppschicht umfasst, wobei die Ätzstoppfunktion der Ätzstoppschicht (6) Stoppen eines Ätzprozesses betrifft, der während des Schritts des Ausdünnens des Vorrichtungswafers von der Rückseite davon angewendet wird.

4. Verfahren nach Anspruch 3, wobei die tiefen parallelen Gräben (10) in die Ätzstoppschicht (6) reichen.

5. Verfahren nach Anspruch 3, wobei die tiefen parallelen Gräben (10) durch die gesamte Dicke der Ätzstoppschicht (6) in den Basis-Wafer (5) gebildet werden.

6. Verfahren nach einem der Ansprüche 4 oder 5, wobei ein spektrometrisches Verfahren zum Überwachen der Tiefe der Gräben (10) während deren Bildung unter Verwendung eines Ätzprozesses verwendet wird, indem aus der Halbleiterschicht (1) und der Ätzstoppschicht (6) freigesetzte Materialien erfasst werden.

7. Verfahren nach einem der vorstehenden Ansprüche, wobei die aktiven Vorrichtungen finnenbasierte Vorrichtungen oder nanoblechbasierte Vorrichtungen sind, und wobei die vergrabenen Stromschienen (32) parallel zu den Finnen (2, 2') oder zu den Nanoblechen der aktiven Vorrichtungen verlaufen.

8. Verfahren nach einem der vorstehenden Ansprüche, wobei das Opfermaterial Wolfram oder amorphes Silizium ist.

9. Verfahren nach einem der vorstehenden Ansprüche, wobei die Deckschicht (15) eine dielektrische Schicht ist.

10. Verfahren nach Anspruch 9, wobei die Deckschicht (15) eine Siliziumnitridschicht ist.

## Revendications

1. Procédé de production d'une puce de circuit intégré, comprenant les étapes de :
- fourniture d'une plaquette de dispositif comprenant une couche semi-conductrice (1) sur le dessus, ladite couche présentant une surface avant et une surface arrière,
- par la suite, production d'une pluralité de tranchées profondes mutuellement parallèles (10) à travers l'épaisseur totale de la couche semi-conductrice (1),
- par la suite, remplissage des tranchées (10) avec un matériau sacrificiel,
- par la suite, gravure en retrait du matériau sacrificiel pour former des rails enterrés (13) de matériau sacrificiel, ci-après appelés rails sacrificiels, avec des tranchées peu profondes (14) formées au-dessus des rails sacrificiels (13),
- par la suite, production d'une couche de recouvrement (15) sur les surfaces intérieures des tranchées peu profondes (14),
- par la suite, remplissage des tranchées peu profondes (14) avec un matériau diélectrique (16),
- par la suite, réalisation des étapes suivantes :
- la production de contacts (20) pour la production de dispositifs actifs sur la surface avant de la couche semi-conductrice (1),
- la formation de cavités par des étapes de lithographie et de gravure et le remplissage desdites cavités avec un matériau électriquement conducteur, formant ainsi des connexions électriquement conductrices (22, 23) entre une pluralité des contacts (20) et les rails sacrificiels (13), sans retirer la couche de recouvrement (15),
- la production desdits dispositifs actifs formant ainsi une extrémité avant de portion de ligne (24) de la puce de CI,
- par la suite, production d'un empilement de couches d'interconnexion sur lesdits dispositifs actifs, formant ainsi une extrémité arrière de portion de ligne (25) de la puce de CI,
- par la suite, retournement de la plaquette de dispositif et fixation de la plaquette à une plaquette porteuse (26),
- par la suite, amincissement de la plaquette de dispositif à partir de la face arrière de celle-ci jusqu'à ce que les rails sacrificiels (13) fassent saillie vers l'extérieur à partir de la surface arrière de la couche semi-conductrice (1), dans lequel, le cas échéant, la couche semi-conductrice elle-même est amincie par rapport aux rails sacrificiels (13),
- par la suite, dépôt d'une couche diélectrique (30) sur la surface arrière de la couche semi-conductrice (1), intégration des portions saillantes des rails sacrificiels (13), et amincissement de la couche diélectrique (30) jusqu'à ce que les rails sacrificiels (13) soient exposés,
- par la suite, retrait du matériau sacrificiel, formant ainsi des tranchées de face arrière (31) partant de la surface arrière de la couche diélectrique (30) et atteignant la couche de recouvrement (15), de façon à ce que ladite couche de recouvrement forme le fond des tranchées de face arrière (31),
- par la suite, retrait de la couche de recouvrement (15) à partir dudit fond des tranchées de face arrière (31),
- par la suite, remplissage des tranchées de face arrière (31) avec un matériau électriquement conducteur, formant ainsi des rails d'alimentation enterrés (32) qui sont en contact avec lesdites connexions électriquement conductrices (22, 23),
- par la suite, planarisation de la plaquette jusqu'à ce que la couche diélectrique (30) et les rails d'alimentation enterrés (32) soient exposés,
- par la suite, production d'un réseau de distribution d'énergie de face arrière incluant des conducteurs (33) formés sur la couche diélectrique (30) pour être en contact avec les rails d'alimentation enterrés (32) à partir de la surface arrière de la couche semi-conductrice (1),
- par la suite, isolement de la plaquette de dispositif, formant ainsi la puce de circuit intégré, dans lequel une portion isolée de la couche semi-conductrice (1) forme le substrat de la puce de CI, ledit substrat comprenant des dispositifs actifs sur sa surface avant et un réseau de distribution d'énergie sur sa surface arrière, dans lequel le réseau de distribution d'énergie est connecté aux dispositifs actifs par l'intermédiaire des rails d'alimentation enterrés (32).

2. Procédé selon la revendication 1, comprenant en outre le dépôt d'un revêtement diélectrique (11) sur les surfaces intérieures des tranchées profondes parallèles (10), avant le dépôt du matériau sacrificiel dans celles-ci.

3. Procédé selon la revendication 1, dans lequel la plaquette de dispositif comprend une plaquette de base (5), une couche d'arrêt de gravure (6) sur la plaquette de base, et ladite couche semi-conductrice (1) sur la couche d'arrêt de gravure, dans lequel la fonction d'arrêt de gravure de la couche d'arrêt de gravure (6) est liée à l'arrêt d'un processus de gravure appliqué durant ladite étape d'amincissement de la plaquette de dispositif à partir de la face arrière de celle-ci.

4. Procédé selon la revendication 3, dans lequel les tranchées parallèles profondes (10) atteignent l'intérieur de la couche d'arrêt de gravure (6).

5. Procédé selon la revendication 3, dans lequel les tranchées parallèles profondes (10) sont formées à travers l'épaisseur totale de la couche d'arrêt de gravure (6) et dans la plaquette de base (5).

6. Procédé selon l'une quelconque des revendications 4 ou 5, dans lequel un procédé de spectrométrie est utilisé pour surveiller la profondeur des tranchées (10), au fur et à mesure que ces tranchées sont formées à l'aide d'un processus de gravure, en détectant les matériaux libérés à partir de la couche semi-conductrice (1) et à partir de la couche d'arrêt de gravure (6).

7. Procédé selon l'une quelconque des revendications précédentes, dans lequel les dispositifs actifs sont des dispositifs à base d'ailettes ou des dispositifs à base de nanofeuilles et dans lequel les rails d'alimentation enterrés (32) s'étendent parallèlement aux ailettes (2, 2') ou aux nanofeuilles desdits dispositifs actifs.

8. Procédé selon l'une quelconque des revendications précédentes, dans lequel le matériau sacrificiel est du tungstène ou du silicium amorphe.

9. Procédé selon l'une quelconque des revendications précédentes, dans lequel la couche de recouvrement (15) est une couche diélectrique.

10. Procédé selon la revendication 9, dans lequel la couche de recouvrement (15) est une couche de nitrure de silicium.
